# EUROPÄISCHE PATENTANMELDUNG

(11) **EP 1 193 506 A2**
(43) Veröffentlichungstag der Anmeldung: **03.04.2002**
(21) Anmeldenummer: 01122224.7
(22) Anmeldetag: 17.09.2001
(51) Int. Cl.: G01R 33/36

(54) **Verfahren zum Abtasten eines hochfrequenten Empfangssignals, insbesondere eines Hochfrequenzsignals einer Empfangsspule eines Magnetresonanzgeräts**

(30) Priorität: 29.09.2000 DE 10048344
(71) Anmelder: SIEMENS AKTIENGESELLSCHAFT, 80333 München (DE)
(72) Erfinder: Baumgartl, Rudi, 91056 Erlangen (DE); Pirkl, Georg, 91077 Dormitz (DE)

(57) **Zusammenfassung**

Verfahren zum Abtasten eines hochfrequenten Empfangssignals, das zu Zwecken der Weiterverarbeitung insbesondere im Rahmen einer Bilderzeugung in ein niederfrequentes Basisband heruntergemischt wird, insbesondere des Hochfrequenzsignals einer Empfangsspule eines Magnetresonanzgeräts, bei welchem Verfahren das hochfrequente Empfangssignal direkt auf einen hochgetakteten Analog-Digital-Wandler gegeben wird, wo es taktabhängig auf eine niedrigere Frequenz gewandelt wird, wonach es durch digitale Demodulation in ein wiederum niederfrequenteres Basisband heruntergemischt wird.

## Beschreibung

Die Erfindung betrifft ein Verfahren zum Abtasten eines hochfrequenten Empfangssignals, das zu Zwecken der Weiterverarbeitung, insbesondere im Rahmen einer Bilderzeugung in ein niederfrequentes Basisband heruntergemischt wird, insbesondere des Hochfrequenzsignals einer Empfangsspule eines Magnetresonanzgeräts.

Bei bekannten Magnetresonanzgeräten wurde das Hochfrequenzsignal, das die aufgenommene Patienteninformation, die im Rahmen eines Magnetresonanzbildes angezeigt werden soll, enthält, und das von einer Empfangsspule aufgenommen wird, mit Hilfe von teuren und aufwendigen Hochfrequenz- und Analogschaltkreisen in das Basisband bzw. auf eine Zwischenfrequenz, die unterhalb der Nyquist-Grenze des Abtasters liegt, heruntergemischt. Dies wurde in einer oder meist in mehreren Stufen realisiert. Dazu waren auch für jede Stufe zusätzliche LO-Trägersignale nötig, die von einem Mutteroszillator, der Teil der aufwendigen Schaltungsanordnung ist, abgeleitet wurden. Dabei mussten die LO-Frequenzen so gelegt werden, dass kein Mischprodukt entstand, welches nachher im Nutzband lag. Fall doch störende Mischprodukte auftraten, wurden diese durch aufwendige Bandpass- und Tiefpassfilter entfernt, was wiederum Schaltungsaufwand und Kosten verursachte.

Falls das Hochfrequenzsignal, das die Nutzinformation enthält, auf das Basisband heruntergemischt wurde, wurde nach dem Heruntermischen das Signal unter Einhaltung des Nyquistkriteriums mit einem hochauflösenden und teuren Analog-Digital-Wandler mit vorgeschaltetem Tiefpassfilter digitalisiert und direkt der Signalweiterverarbeitung zur Erzeugung des Magnetresonanzbildes zugeführt. Bei einer Mischung des hochfrequenten Empfangssignals in eine Zwischenfrequenzlage und anschließender Digitalisierung war zusätzlich noch eine digitale Demodulation erforderlich, um das Signal in das Basisband zu führen. Bei der Digitalisierung wurde wiederum das Nyquistkriterium eingehalten.

Insgesamt ist die Abtastung eines hochfrequenten Empfangssignals im Bereich von Magnetresonanzgeräten mit einem sehr hohen Schaltungsaufwand verbunden, der äußerst komplex und kostenintensiv ist.

Der Erfindung liegt das Problem zugrunde, ein Verfahren zur Abtastung anzugeben, das eine sichere Signalabtastung mit geringem Schaltungsaufwand ermöglicht.

Zur Lösung dieses Problems ist bei einem Verfahren der eingangs genannten Art erfindungsgemäß vorgesehen, dass das hochfrequente Empfangssignal direkt auf einen hochgetakteten Analog-Digital-Wandler gegeben wird, wo es taktabhängig auf eine niedrigere Frequenz gewandelt wird, wonach es durch digitale Demodulation in ein wiederum niederfrequenteres Basisband heruntergemischt wird.

Anders als im Stand der Technik wird beim erfindungsgemäßen Verfahren das hochfrequente Empfangssignal nicht vor dem Digitalisieren in das Basisband heruntergemischt, vielmehr wird erfindungsgemäß das Empfangssignal direkt auf einen hochgetakteten, breitbandigen und schnellen Analog-Digital-Wandler gegeben. Aufgrund der Taktung des Analog-Digital-Wandlers liegt nach der Wandlung das digitale Wandlersignal in einem Frequenzbereich, der abhängig von der Taktfrequenz niedriger ist als die ursprüngliche Signalfrequenz. Hinsichtlich der Abtastfrequenz ist lediglich zu beachten, dass die Abtastung unterhalb des Nyquistkriteriums, aber unter Einhaltung des erweiterten Nyquistkriteriums erfolgt. Die Möglichkeit, den Analog-Digital-Wandler direkt mit dem hochfrequenten Empfangssignal zu beaufschlagen, ergibt sich aus dem Umstand, dass neuerdings Wandler zur Verfügung stehen, die sehr breitbandig arbeiten und äußerst rauscharm sind bei gleichzeitig sehr hoher Taktfrequenz. Diese Wandlergeneration ermöglicht das Verarbeiten auch hoher Empfangssignalfrequenzen, wie sie beim Empfangssignal eines Magnetresonanzgeräts gegeben sind, wo je nach Auslegung der Anlage Empfangssignale mit Frequenzen auch überhalb von 60 MHz empfangen werden.

Nach dem Nyquistkriterium ist es für die Wiederherstellbarkeit des Empfangssignals erforderlich, dass die Abtastfrequenz mindestens der doppelten Signalfrequenz entspricht. Durch die Abtastung wird das Frequenzpaket periodisch und abhängig von der Abtastfrequenz auf dem sich von -∞ bis +∞ erstreckenden Frequenzband mehrfach wiederholt. Liegt die Abtastfrequenz unterhalb dem Nyquistkriterium, so ergeben sich Signalüberlagerungen und damit "Mischprodukte", die ein Wiederherstellen des Empfangssignals nach der Digitalisierung verkomplizieren. Liegt die Abtastfrequenz jedoch im oder über dem Nyquistkriterium, so ist eine Wiederherstellbarkeit möglich, da es nicht zu Überlagerungseffekten kommt.

Nach dem erweiterten Nyquistkriterium ist es für eine reproduzierbare Abtastung ausreichend, wenn die Abtastfrequenz mindestens dem doppelten der Bandbreite des Nutzsignals, hier des die Nutzinformation tragenden Empfangssignals der Empfängerspule entspricht. Beträgt die beispielsweise durch vorherige Filterung begrenzte Bandbreite des Signals beispielsweise ± 250 kHz, so muss die Abtastfrequenz mindestens 1 MHz betragen. Liegt also ein in seiner Bandbreite begrenztes Signal vor, so ist es in der Regel ausreichend, wenn die Abtastung lediglich das erweiterte Nyquistkriterium einhält, d. h., es kann mit einer Frequenz unterhalb der doppelten Signalfrequenz, jedoch wenigstens der doppelten Bandbreite des Signals entsprechend abgetastet werden.

Da das die zur Bildverarbeitung erforderliche Nutzinformation tragende Empfangssignal relativ schmalbandig ist, ist es bei Magnetresonanzgeräten möglich, mit Abtastfrequenzen zu arbeiten, die weit unterhalb dem Nyquistkriterium liegen.

Das bereits gegenüber dem Empfangssignal deutlich niederfrequentere digitale Wandlersignal wird anschließend digital demoduliert und in das niederfrequente Basisband heruntergemischt. Zur Demodulation kann jedes geeignete bekannte Demodulationsverfahren angewendet werden.

Insgesamt lässt das erfindungsgemäße Verfahren eine sichere Abtastung mit deutlich niedrigerem Schaltungsaufwand zu, da keine aufwendigen und teuren Hochfrequenz- und Analogschaltkreise mehr nötig sind, die beim Stand der Technik zum Heruntermischen des hochfrequenten Empfangssignals vorgesehen sind. Infolgedessen ist es möglich, die Abtastschaltungsanordnung sehr klein zu halten und an geeigneter Stelle auf bereits vorhandenen Schaltungsboards zu integrieren. Umgekehrt besteht die Möglichkeit, den Analog-Digital-Wandler direkt in die Spule zu integrieren, so dass in diesem Fall das bereits niederfrequentere Wandlersignal an die nachfolgende Demodulationsstufe, die extern zur Spule liegt, geführt wird.

Zur Verringerung des Rauschanteils im hochfrequenten Empfangssignal ist es zweckmäßig, wenn das Empfangssignal vor der Gabe an den Analog-Digital-Wandler mittels eines Bandpassfilters gefiltert wird. Mit diesem Filter, der das Empfangssignal zweckmäßigerweise auf eine Bandbreite im Bereich zwischen ± 100 kHz bis ± 500 kHz, insbesondere von ± 250 kHz um die Empfangssignalfrequenz herum filtert, ist es möglich, die darüber und darunter liegenden Frequenzen, die kein Nutzsignal, sondern lediglich Rauschen enthalten, herauszufiltern, so dass der Wandler lediglich das gefilterte und wesentlich rauschärmere Empfangssignal zu verarbeiten hat.

Weiterhin ist es vorteilhaft, wenn das Empfangssignal vor der Gabe an den Analog-Digital-Wandler und zweckmäßigerweise vor der vorherigen Filterung verstärkt wird. Über diese Verstärkung kann eine Signalanpassung an die Leistungsparameter des Analog-Digital-Wandlers erfolgen, um diesen gut auszusteuern.

Zur Demodulation wird zweckmäßigerweise eine Mulitplizierstufe verwendet. Weiterhin kann nach der Demodulation in einer digitalen Tiefpassfilterstufe eine Datenreduktion erfolgen, denn für die nachfolgende Signalverarbeitung ist das sich aus der hohen Abtastfrequenz, die im Bereich mehrerer -zig MHz liegen kann, gegebene Datenvolumen zu groß, zur Bilderzeugung werden derart viele Daten auch nicht benötigt.

Neben dem erfindungsgemäßen Verfahren betrifft die Erfindung ferner ein Magnetresonanzgerät mit einer Schaltungsanordnung zum Abtasten eines hochfrequenten Empfangssignals einer Empfangsspule, wobei die Schaltungsanordnung umfasst:
- einen hochgetakteten Analog-Digital-Wandler, auf den das hochfrequente Empfangssignal direkt gebbar ist, zum taktabhängigen Wandeln des hochfrequenten Empfangssignals auf eine niedrigere Frequenz und
- eine dem Analog-Digital-Wandler nachgeschaltete digitale Demodulationseinrichtung zum Heruntermischen des digitalen Ausgangssignals des Analog-Digital-Wandlers in ein niederfrequenteres Basisband.

Erfindungsgemäß kann dem Analog-Digital-Wandler ein Bandpassfilter zum Begrenzen des Empfangssignals auf eine bestimmte Bandbreite vorgeschalten sein, bevorzugt wird eine Bandbreite im Bereich von ± 100 kHz bis ± 500 kHz, insbesondere von ± 250 kHz. Dem Wandler kann ferner eine Verstärkereinrichtung zum Verstärken des Empfangssignals vorgeschaltet sein, wobei diese Verstärkereinrichtung so ausgelegt ist, dass das eingehende Empfangssignal zur optimalen Anpassung des Signals an die Leistungsparameter des Analog-Digital-Wandlers ausgelegt ist. Bekannte Analog-Digital-Wandler brauchen eine Signalamplitude von ca. 1 V, wo hingegen die Empfangsspule Signale in der Größenordnung von ca. 0,1 V liefern.

Ferner kann vorgesehen sein, dass die Demodulationseinrichtung eine Mulitplizierstufe umfasst, wobei der Demodulationseinrichtung zweckmäßigerweise zur Datenreduktion wenigstens eine Tiefpassfilterstufe nachgeschalten ist. Schließlich kann der Analog-Digital-Wandler direkt in die Empfangsspule integriert sein.

Weitere Vorteile, Merkmale und Einzelheiten der Erfindung ergeben sich aus dem im folgenden beschriebenen Ausführungsbeispiel sowie anhand der Zeichnungen. Dabei zeigen:
- Fig. 1: zeigt in Form einer Prinzipskizze ein erfindungsgemäßes Magnetresonanzgerät mit einer Abtastschaltungsanordnung, und
- Fig. 2: eine Prinzipskizze des Signalfrequenzspektrums vor und nach der Wandlung.

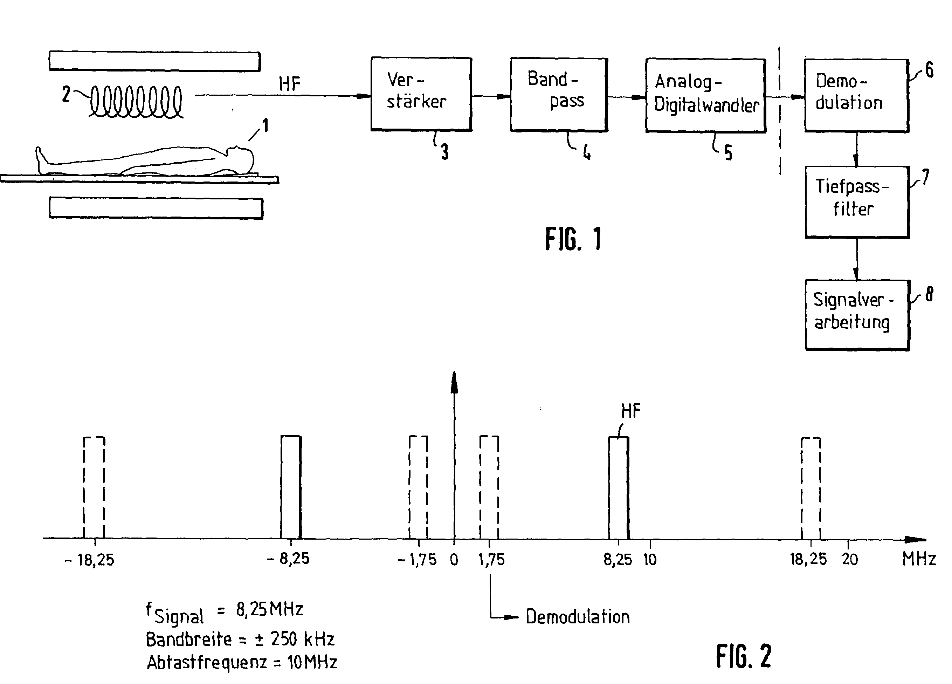

Fig. 1 zeigt ein erfindungsgemäßes Magnetresonanzgerät in Form einer Prinzipskizze. Gezeigt ist ein Patient 1. Nach entsprechender Anregung wird mittels einer Empfangsspule 2 ein Hochfrequenz-Empfangssignal HF empfangen. Die Funktionsweise eines Magnetresonanzgeräts ist an für sich bekannt, ein näheres Eingehen hierauf ist nicht erforderlich, da es für die Erfindung lediglich auf den Bereich der Abtastung des Hochfrequenz-Empfangssignals ankommt.

Dieses Hochfrequente-Empfangssignal HF wird anschließend in einer Verstärkereinrichtung 3 derart verstärkt, dass eine optimale Anpassung an die Leistungsparameter eines nachgeschalteten Analog-Digital-Wandlers 5 erfolgt. Anschließend wird das verstärkte Signal mittels eines Bandpassfilters 4 gefiltert, um höher- und niederfrequentere Rauschanteile herauszufiltern, das gefilterte Nutzband hat beispielsweise eine Bandbreite von ± 250 kHz. Das Empfangssignal ist trotz Filterung und Verstärkung nach wie vor hochfrequent. Im Analog-Digital-Wandler 5 erfolgt nun eine Frequenzerniedrigung des Empfangssignals bei gleichzeitiger Digitalisierung. Die Abtastfrequenz des Analog-Digital-Wandlers ist derart gewählt, dass sie unterhalb des Nyquistkriteriums, jedoch unter Einhaltung des erweiterten Nyquistkriteriums ist. Demgemäß beträgt die Abtastfrequenz bei einer infolge der Bandpassfilterung gegebenen Nutzbandbreite von beispielsweise ± 250 kHz wenigstens 1 MHz. Die sich aus dem Nyquistkriterium ergebende Abtastfrequenz beträgt je nach Auslegung des Magnetresonanzgeräts mehrer MHz. So liefert beispielsweise ein 0,2 T-Magnetresonanzgerät ein Empfangssignal von 8,25 MHz. Gemäß dem Nyquistkriterium müsste die Abtastfrequenz wenigstens 16,5 MHz betragen, um eine reproduzierbare Abtastung zu erhalten. Da das Nutzband lediglich hier beispielsweise 500 kHz breit ist, kann jede beliebige Abtastfrequenz zwischen 1 MHz und der Nyquistabtastfrequenz gewählt werden. Eine Abtastung kann hier beispielsweise mit einem Wandlertakt von 10 MHz erfolgen. Bezüglich der Wandlerfunktion wird in Fig. 2 noch näher eingegangen. Der Wandler sowie die Verstärker- und die Filtereinrichtung können an der Spule angeordnet sein, wie durch die gestrichelte Linie angedeutet ist.

Nach erfolgter Digitalisierung wird das digitale Wandlersignal, das aufgrund der Digitalisierung weitgehend störungsunanfällig ist und infolgedessen von weiteren Geräteelementen nicht mehr beeinflusst wird, in einer Demodulationseinrichtung 6 demoduliert und in ein gewünschtes Basisband heruntergemischt. Anschließend erfolgt in einer Tiefpassfilterstufe 7 eine Tiefpassfilterung zur Datenreduktion, wonach die Signale an eine Signalverarbeitungseinrichtung 8, die die Signale zur Bilderzeugung verarbeitet, weitergegeben.

Fig. 2 zeigt die Wirkungsweise des Analog-Digital-Wandlers bei einer unterhalb des Nyquistkriteriums, jedoch das erweiterte Nyquistkriterium einhaltenden Abtastfrequenz. Aufgetragen ist längs der Abszisse das Frequenzspektrum von -∞ bis +∞, längs der Ordinate die Signalamplitude. Das Empfangssignal HF hat im gezeigten Beispiel eine Frequenz von 8,25 MHz bei einer Bandbreite von ± 250 kHz. Die Abtastfrequenz des Analog-Digital-Wandlers beträgt 10 MHz. Das Empfangssignal liegt sowohl positiv als auch negativ vor, d. h., auch bei einer Frequenz von -8,25 MHz ist das Empfangssignal gegeben.

Aufgrund der Abtastfrequenz von 10 MHz wiederholt sich das Empfangssignal periodisch bei einer Frequenz von f = f_{HF} ± n*fAbtast. Im gezeigten Ausführungsbeispiel bedeutet dies, das das Empfangssignal bei 8,25 MHz auch bei einer Frequenz von 18,25 MHz, 28,25 MHz etc. sowie bei -1,75 MHz, -11,75 MHz usw. vorliegt. Entsprechendes gilt für das Empfangssignal bei -8,25 MHz, dieses liegt bei +1,75 MHz usw. sowie bei -18,25 MHz usw. vor. Zur Demodulation wird das niederfrequente Signal bei 1,75 MHz verwendet, welches anschließend auf das Basisband heruntergemischt wird.

Als zweites Beispiel wird ein 1T-Magnetresonanzgerät mit einem Empfangssignal von 40,45 MHz, welches wiederum mit einem Bandpassfilter auf ein Nutzband von z. B. ± 250 kHz begrenzt wird, betrachtet. Beispielsweise wird hier eine Abtastfrequenz von 30 MHz gewählt. Diese Abtastfrequenz liegt sowohl unterhalb dem Nyquistkriteriums als auch unterhalb der Signalfrequenz selbst, hält jedoch immer noch das erweiterte Nyquistkriterium ein. Entsprechend der bereits zur Fig. 2 erläuterten taktabhängigen periodischen Signalwiederholung liegt hier ein Signal bei 10,45 MHz (Empfangssignalfrequenz - Abtastfrequenz = 40,45 MHz - 30 MHz) vor. Diese Signalfrequenz kann als Zwischenfrequenz aufgefasst werden, welche über eine digitale Demodulation in das Basisband heruntergemischt wird.

Ersichtlich können auch andere geeignete Abtastfrequenzen genommen werden, um nach der Digitalisierung ein digitales Wandlersignal bei anderen Frequenzlagen zu erhalten.

## Patentansprüche

1. Verfahren zum Abtasten eines hochfrequenten Empfangssignals, das zu Zwecken der Weiterverarbeitung insbesondere im Rahmen einer Bilderzeugung in ein niederfrequentes Basisband heruntergemischt wird, insbesondere des Hochfrequenzsignals einer Empfangsspule eines Magnetresonanzgeräts, bei welchem Verfahren das hochfrequente Empfangssignal direkt auf einen hochgetakteten Analog-Digital-Wandler gegeben wird, wo es taktabhängig auf eine niedrigere Frequenz gewandelt wird, wonach es durch digitale Demodulation in ein wiederum niederfrequenteres Basisband heruntergemischt wird.

2. Verfahren nach Anspruch 1, bei welchem das Empfangssignal vor der Gabe an den Analog-Digital-Wandler mittels eines Bandpassfilters gefiltert wird.

3. Verfahren nach Anspruch 1 oder 2, bei welchem das Empfangssignal vor der Gabe an den Analog-Digital-Wandler verstärkt wird.

4. Verfahren nach einem der vorangehenden Ansprüche, bei welchem im Rahmen der digitalen Demodulation eine Multiplizierstufe verwendet wird.

5. Verfahren nach einem der vorangehenden Ansprüche, bei welchem nach der Demodulation in einer digitalen Tiefpassfilterstufe eine Datenreduktion erfolgt.

6. Magnetresonanzgerät mit einer Schaltungsanordnung zum Abtasten eines hochfrequenten Empfangssignals einer Empfangsspule, wobei die Schaltungsanordnung umfasst:
- einen hochgetakteten Analog-Digital-Wandler (5), auf den das hochfrequente Empfangssignal (HF) direkt gebbar ist, zum taktabhängigen Wandeln des hochfrequenten Empfangssignals (HF) auf eine niedrigere Frequenz, und
- eine dem Analog-Digital-Wandler (5) nachgeschaltete digitale Demodulationseinrichtung (6) zum Heruntermischen des digitalen Ausgangssignals des Analog-Digital-Wandlers (5) in ein niederfrequenteres Basisband.

7. Magnetresonanzgerät nach Anspruch 6, **dadurch gekennzeichnet, dass** dem Analog-Digital-Wandler (5) ein Bandpassfilter (3) zum Begrenzen des Empfangssignals (HF) auf eine bestimmte Bandbreite vorgeschalten ist.

8. Magnetresonanzgerät nach Anspruch 6 oder 7, **dadurch gekennzeichnet, dass** dem Analog-Digital-Wandler (5) eine Verstärkereinrichtung (4) zum Verstärken des Empfangssignals (HF) vorgeschalten ist.

9. Magnetresonanzgerät nach einem der Ansprüche 6 bis 9, **dadurch gekennzeichnet, dass** die Demodulationseinrichtung (6) eine Multiplizierstufe umfasst.

10. Magnetresonanzgerät nach einem der Ansprüche 6 bis 9, **dadurch gekennzeichnet, dass** ferner eine der Demodulationseinrichtung (6) nachgeschaltete Tiefpassfilterstufe (7) zur Datenreduktion nachgeschalten ist.

11. Magnetresonanzgerät nach einem der Ansprüche 6 bis 10, **dadurch gekennzeichnet, dass** der Analog-Digital-Wandler (5) ggf. auch das Bandpassfilter (3) und die Verstärkereinrichtung (4) direkt in oder an der Empfangsspule (2) integriert ist.
